# EUROPEAN PATENT SPECIFICATION

(11) **EP 0 361 461 B1**
(45) Date of publication and mention of the grant of the patent: **26.04.1995**
(21) Application number: 89117907.9
(22) Date of filing: 28.09.1989
(51) Int. Cl.: H05K 1/03, H01L 23/14, B01F 3/20, C08L 79/08

(54) **Process for producing metal-polyimide composite article**
Verfahren zur Herstellung von Metall-Polyimid-Verbundwerkstoffen
Procédé de production d'un article composé de métal/polyimide

(30) Priority: 30.09.1988 JP 243986/88
(43) Date of publication of application: 04.04.1990
(73) Proprietor: HITACHI, LTD., Chiyoda-ku, Tokyo 101 (JP)
(72) Inventor: Numata, Shunichi, Hitachi-shi (JP); Miwa, Takao, Katsuta-shi (JP); Ikeda, Takayoshi, Naka-gun Ibaraki-ken (JP); Fujisaki, Koji, Hitachi-shi (JP); Shimanoki, Hisae, Hitachi-shi (JP); Miyazaki, Kunio, Hitachi-shi (JP); Miura, Osamu, Hitachi-shi (JP); Watanabe, Ryuji, Naka-gun Ibaraki-ken (JP); Miyamoto, Toshio, Takasaki-shi (JP); Okoshi, Yukio, Mito-shi (JP)
(74) Representative: Beetz & Partner Patentanwälte

(56) References cited:
- EP-A- 0 116 297
- EP-A- 0 130 417
- EP-A- 0 143 531
- EP-A- 0 251 828
- FR-A- 1 571 736
- GB-A- 1 076 722
- US-A- 4 338 427
- PATENT ABSTRACTS OF JAPAN, vol. 8, no. 93 (C-220)[1530], 27th April 1984;& JP-A-59 8731
- PATENT ABSTRACTS OF JAPAN, vol. 12, no. 242 (C-510)[3089], 8th July 1988;& JP-A-63 33 422
- PATENT ABSTRACT OF JAPAN, vol.12, no. 70 (C-479) (2917), 4th March 1988; & JP-A-62 207 331.

## Description

The present invention relates to a process for producing metal-polyimide composite articles and particularly to a process for producing circuit boards exhibiting a very small delay time. The composite articles of the present invention comprise a polyimide which is low in dielectric constant and high in heat resistance as an insulating film, and copper or silver as low resistance conductors in the wiring layer. The materials thus produced can be used particularly for high-density and high-speed wiring boards for future computers of large to middle or small size and flexible printed boards which are essential for miniaturization of electronic parts.

Hitherto, there have been used multi-layer circuit boards comprising an epoxy or maleimide resin-glass cloth laminate and copper foil, and alumina/ tungsten multi-layered circuit boards as high density wiring boards. However, in the former case, there are limitations in the production methods and materials, and a fine wiring width of less than 30 »m cannot be obtained, and in the latter case, tungsten of high heat resistance with high resistivity must be used because ceramics are high in dielectric constant, and a very high temperature process is required for production. Thus, there was a demand for wiring boards of high performance as future high-speed and high-density wiring boards to be used in place of the above conventional wiring boards.

Copper/polyimide wiring boards are produced by forming a polyimide of low dielectric constant and using copper of low resistivity on a silicon wafer or a ceramic substrate by the same fine process as used for the production of semiconductor wirings. By this method, it can be expected that wiring boards of high performance are obtained.

However, there is the problem that when a polyamic acid which is a polyimide precursor, is heated and cured in contact with copper or silver at temperatures higher than 300°C, a pyrolysis reaction occurs which cannot be considered to occur in view of the heat resistance of polyimide per se. For example, it has been known that when a polyamic acid varnish is coated on a film of copper and heat cured, distinct discoloration is recognized above 300°C, and the film becomes mechanically very brittle. Similar phenomena are recognized to occur during the production of flexible printed boards or the curing of electrically conductive silver paste. In case of metals, this problem is especially conspicuous for copper and silver, and nearly no problem is seen for aluminum, titanium, nickel and chromium.

Up to now, in forming an imidized film in contact with a metal, the following methods have been employed, namely, a method of forming a metallic film such as of inert chromium or an inert film of SiO₂ or Si₃N₄ and coating thereon a polyamic acid precursor varnish and heating and curing the varnish, and a method of heating and curing the varnish in a reducing atmosphere such as hydrogen when the varnish is in direct contact with the metal. These methods suffer from severe problems such as a considerable increase in the number of steps and increased running cost.

Taking the hint from the fact that even if a film of such metal is formed on a polyimide film and heated, substantially no adverse effect occurs to the polyimide film, the inventors coated a varnish of a polyamic acid on a metallic film and heated and cured the varnish and as a result have found that no deterioration of polyimide occurs. However, this method still has the problems that since the solubility of polyimide is very poor, cresol type solvents which are harmful to human must be used, and only special solvents which are highly soluble in polyimides per se can be used.

As a result of investigations for solving these problems, it has been found that when a polyamic acid the carboxylic acid of which is esterified by an alcohol is used, no problem occurs. However, since this polyamic acid whose carboxylic acid is esterified is obtained by reacting an acid anhydride with an alcohol, then converting the product to an acid chloride with thionyl chloride and then further reacting the acid chloride with a diamine, there are many problems to be solved in that preparation steps are much prolonged, and ionic impurities are incorporated at preparation steps to cause troubles in use.

The object of the present invention is to provide metal/polyimide composite molded articles of high reliability which are prevented from heat deterioration of the polyimide film which may occur when a conventional polyamic acid is coated on a metallic film of copper or silver and cured with heat and which is prevented from deterioration even when it is produced in an atmosphere which is not a special one such as a reducing atmosphere.

The above object is achieved according to the independent claims.

The dependent claims relate to preferred embodiments.

The inventors have carefully studied the chemical reaction of polyimide precursors and copper and silver which takes place in the course of the production of metal/polyimide composites which includes thermal imidization in contact of polyimide precursor with the metal. As a result, it has been found that metal is dissolved in the presence of carboxylic acid groups of the polyamic acid, and subsequently, when it is exposed to high temperature, imide rings are decomposed by the metal, and simultaneously particulate metal oxide is precipitated. Furthermore, it has also been found that similar phenomena occur for polyimide precursors having sulfonic acid groups, and the presence of acidic functional groups causes dissolution of the metal. The present invention has been accomplished based on this finding.

GB-A-1 076 722 discloses silylated polyamic acid resins and polyimides derived therefrom, wherein the silylation may be present in the form of silyl ester groups or in the form of aminosilyl groups of the diamine component. The use of silylated diamines allows the use of solvents having much lower boiling points as compared with the use of non-silylated diamine compounds, so that the problems of poor solubility of the polyamic acids, which are the polyimide precursors, and of the removal of the solvent at low temperature after application to a substrate have been solved according to this prior art. This document, however, is silent about the problem of pyrolysis of the polyimide precursor occuring at temperatures above 300 °C if it is in contact with copper or silver, leading to brittleness and discoloration of the resulting polyimide film.

EP-A-0 116 297 discloses polyimide/copper laminates made by transforming a polyamic acid solution coating into a polyimide by heating at temperatures above 300°C.

The present process for producing copper or silver/polyimide composite articles includes the step of imidization of a polyimide precursor in contact with the metal which is characterized in that acidic functional groups such as carboxy groups, sulfonic groups, or the like in the polyimide precursor are masked.

According to the present invention, there is provided a process for producing copper or silver/polyimide composite articles, comprising:
providing a precursor of a polyimide in contact with the copper or silver material; and
heating the precursor until it turns into the polyimide, wherein the precursor is selected from polyamic acid epoxy adducts, amido polyamic acids and reaction products of an organic diisocyanate compound and a tetracarboxylic acid dianhydride.

In another aspect of the present invention, there is provided a process for producing printed circuit boards, comprising the following steps:

Forming a copper film on an electrically insulating substrate;
coating a precursor of a polyimide on the copper film, and
heating the polyimide precursor until it turns into the polyimide, wherein the polyimide precursor is selected from polyamic acid epoxy adducts, amido polyamic acids, and reaction products of an organic diisocyanate compound and a tetracarboxylic acid dianhydride. In a further aspect of the present invention, there is provided a process for producing copper or silver/polyimide compositions, comprising:

Providing a homogeneous mixture of a precursor of a polyimide, minutes of copper or silver and an organic solvent for dissolving the polyimide precursor, and
heating the mixture until the polyimide precursor turns into the polyimide, wherein the polyimide precursor used is selected from polyamic acid epoxy adducts, amido polyamic acids, and reaction products of an organic diisocyanate compound and a tetracarboxylic acid dianhydride.

In a still further aspect of the present invention, there is provided a process for producing multi-layer printed circuit boards, which comprises the following steps:
(A) forming a circuit pattern of a copper film on an electrically insulating substrate,
(B) coating a varnish of a precursor of a polyimide on the circuit pattern,
(C) heating the varnish until the polyimide precursor turns into the polyimide,
(D) patterning the polyimide to form through-holes therein, and
(E) forming a circuit pattern of copper on the patterned polyimide,

steps B to E being repeated until a desired number of layers is obtained, wherein the polyimide precursor is selected from polyamic acid epoxy adducts, amido polyamic acids, and reaction products of an organic diisocyanate compound and a tetracarboxylic acid dianhydride.

The polyimide precursors used in the present invention include, for example, the following:

Polyamic acid epoxy adducts I or II having the following chemical structure which are obtained, for example, by reacting a polyamic acid with a compound having at least one epoxy group: 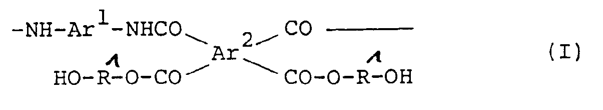
or 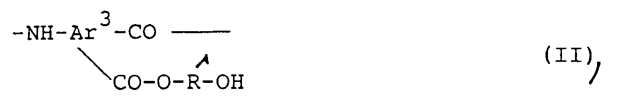
wherein are:
- R¹: a residue of an epoxy compound,
- Ar¹: a residue of a diamine compound,
- Ar²: a residue of tetracarboxylic acid,
and
- Ar³: a residue of an aminodicarboxylic acid;

amido polyamic acids III or IV which are reaction products of, for example, an isocyanate compound with a polyamic acid: 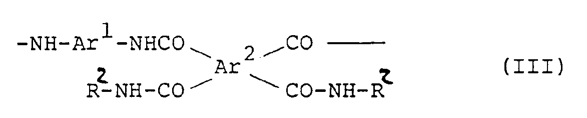
or 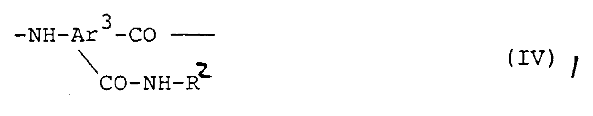
wherein Ar¹, Ar², Ar³ are as defined above, and R² is a residue of an isocyanate;
products V obtained by reaction of a diisocyanate compound with a tetracarboxylic acid dianhydride: 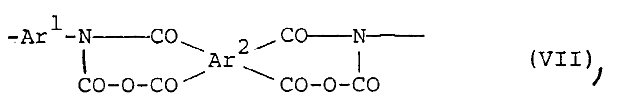
wherein Ar² is as defined above, and Ar¹ is a residue of a diisocyanate.

Of these masked polyamic acids which are precursors for polyimides, I and II have the features that the reactivity is superior, and adverse impurities are not produced by the condensation reaction, but the problem that relatively large amounts of condensation product volatilize at the imidization, and hence the curing shrinkage is somewhat high; III and IV have the problem that since they include reaction with an isocyanate compound, the polyamic acid reacts even at low temperature, and if unreacted functional groups remain, carbon dioxide is generated to cause bubbling; the product of formula (VII) are easy to prepare, but have a problem in the stability because with progress of the reaction, imidization occurs with generation of carbon dioxide. As explained above, the polyimide precursors thus have respective characteristics depending on the differences in the masking method, and they are used properly depending on the use.

Of the above polyimide precursors, I to IV can be obtained by reacting a polyamic acid obtained by homopolymerization of an aminodicarboxylic acid derivative or reaction of a diamine with a tetracarboxylic acid derivative with an epoxy compound or an isocyanate compound. The tetracarboxylic acid derivative includes acid anhydrides and acid chlorides. The acid anhydrides are preferred for preparation.

The reaction for the preparation of polyamic acids is generally carried out at -20 to 200°C in solvents such as N-methylpyrrolidone (NMP), dimethylformamide (DMF), dimethylacetamide (DMAC), dimethylsulfoxide (DMSO), dimethyl sulfate, sulforan, butyl lactone, cresol, phenol, halogenated phenols, cyclohexanone, dioxane, tetrahydrofuran, and acetophenone.

As examples of the aminodicarboxylic acids used in the present invention, mention may be made of 4-aminophthalic acid, 4-amino-5-methylphthalic acid, 4-(p-anilino)-phthalic acid, and 4-(3,5-dimethyl-4-anilino)phthalic acid, and acid anhydrides and acid chlorides thereof.

The diamines used in the present invention include, for example, aromatic diamines such as p-phenylenediamine (p-PDA), 2,5-diaminotoluene, 2,5-diaminoxylene, diaminodurene(2,3,5,6-tetramethylphenylenediamine), 2,5-diaminobenzotrifluoride, 2,5-diaminoanisole, 2,5-diaminoacetophenone, 2,5-diaminobenzophenone, 2,5-diaminodiphenyl, 2,5-diaminofluorobenzene, benzidine, o-tolidine (o-TLD), m-tolidine, 3,3′,5,5′-tetramethylbenzidine, 3,3′-dimethoxybenzidine, 3,3′-di(trifluoromethyl)benzidine, 3,3′-diacetylbenzidine, 3,3′-difluorobenzidine, octafluorobenzidine, 4,4˝-diaminoterphenyl (DATP), and 4,4‴-diaminoquaterphenyl which have linear conformations, and m-phenylenediamine, 4,4′-diaminodiphenylmethane, 1,2-bis(anilino)ethane, 4,4′-diaminodiphenyl ether (DDE), diaminodiphenylsulfone, 2,2-bis(p-aminophenyl)propane, 2,2-bis(p-aminophenyl)hexafluoropropane, 3,3′-dimethyl-4,4′-diaminodiphenyl ether, 3,3′-dimethyl-4,4′-diaminodiphenylmethane, diaminotoluene, diaminobenzotrifluoride, 1,4-bis(p-aminophenoxy)benzene, 4,4′-bis(p-aminophenoxy)biphenyl, 2,2-bis{4-(p-aminophenoxy)-phenyl}propane, 2,2-bis{4-(m-aminophenoxy)-phenyl}propane, 2,2-bis{4-(p-aminophenoxy)-phenyl}hexafluoropropane, 2,2-bis{4-(m-aminophenoxy)-phenyl}hexafluoropropane, 2,2-bis{4-(p-aminophenoxy)-3,5-dimethylphenyl}hexafluoropropane, 2,2-bis{4-(p-aminophenoxy)-3,5-ditrifluoromethylphenyl}hexafluoropropane, p-bis(4-amino-2-trifluoromethylphenoxy)benzene, 4,4′-bis(4-amino-2-trifluoromethylphenoxy)biphenyl, 4,4′-bis(4-amino-3-trifluoromethylphenoxy)biphenyl, 4,4′-bis(4-amino-2-trifluoromethylphenoxy)diphenylsulfone, 4,4′-bis(3-amino-5-trifluoromethylphenoxy)diphenyl-sulfone, 2,2-bis{4-(p-amino-3-trifluoromethylphenoxy)-phenyl}hexafluoropropane, diaminoanthraquinone, 4,4-bis(3-aminophenoxyphenyl)diphenylsulfone, 1,3-bis(anilino)hexafluoropropane, 1,4-bis(anilino)octafluorobutane, 1,5-bis(anilino)decafluoropentane and 1,7-bis(anilino)tetradecafluoroheptane. Moreover, diaminosiloxanes represented by the formula: 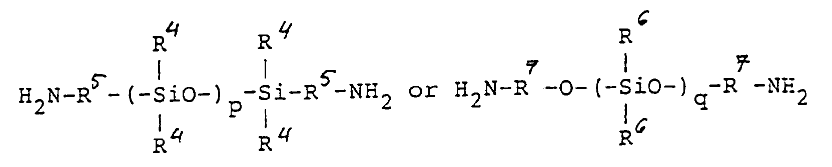
wherein R⁵ and R⁷ each represents a divalent organic group, R⁴ and R⁶ each represents a monovalent organic group and p and q each denotes an integer of more than 1, may also be used as diamines.

The following tetracarboxylic acids and their derivatives can be used in the present invention: Pyromellitic acid (PMDA), methylpyromellitic acid, dimethylpyromellitic acid, bis(trifluoromethyl)pyromellitic acid, 3,3′,4,4′-biphenyltetracarboxylic acid (s-BPDA), 5,5′-dimethyl-3,3′,4,4′-biphenyltetracarboxylic acid, p-(3,4-dicarboxyphenyl)-benzene, 2,3,3′,4′-tetracarboxydiphenyl, 3,3′,4,4′-tetracarboxydiphenyl ether, 2,3,3′,4′-tetracarboxydiphenyl ether, 3,3′,4,4′-tetracarboxybenzophenone (BTDA), 2,3,3′,4′-tetracarboxybenzophenone, 2,3,6,7-tetracarboxynaphthalene, 1,4,5,7-tetracarboxynaphthalene, 1,2,5,6-tetracarboxynaphthalene, 3,3′,4,4′-tetracarboxydiphenylmethane, 2,3,3′,4′-tetracarboxydiphenylmethane, 2,3-bis(3,4-dicarboxyphenyl)propane, 2,2-bis(3,4-dicarboxyphenyl)hexafluoropropane, 3,3′,4,4′-tetracarboxydiphenylsulfone, 3,4,9,10-tetracarboxyperylene, 2,2-bis{4-(3,4-dicarboxyphenoxy)-phenyl}propane, 2,2-bis{4-(3,4-dicarboxyphenoxy)-phenyl}hexafluoropropane, butanetetracarboxylic acid, and cyclopentanetetracarboxylic acid. Acid anhydrides and acid chlorides may also be used.

The polyamic acid epoxy adducts I and II can be obtained, for example, by reacting the thus obtained polyamic acid with a compound having at least one epoxy group. This has the merit that polyimide precursors of high molecular weight can be prepared very easily by reaction of the polyamic acid with epoxy resins, as compared with the preparation of conventional polyamic acids by polycondensation of esterified tetracarboxylic acid and diamines using a dehydrating agent, or by converting the polyamic acid in to an acid chloride and then reacting it with an alcohol. The reaction of the polyamic acid with the epoxy compound can be carried out only by heating them at a temperature higher than 60°C, but in order to carry out the reaction at as low a temperature as possible without allowing imidization reaction to take place, it is preferred to use a curing accelerator for epoxy resins such as a tertiary amine, an imidazole, or triphenylphosphine as a catalyst.

The amido polyamic acids III and IV can be obtained, for example, by reacting the polyamic acid with a compound having at least one isocyanate group. This is also easily achieved by reacting the polyamic acid with the isocyanate compound at a temperature from room temperature to about 100°C.

The polyimide precursor V which is a reaction product of an organic diisocyanate and a tetracarboxylic acid dianhydride also has no acidic functional groups and so metal is hardly dissolved and incorporated therein and thus there is substantially no problem of deterioration of the polyimide film at high temperatures.

Other merits of the processes of the present invention are that the varnishes have a low viscosity and are superior in stability.

The polyimide precursor films can be formed by the generally employed spin coat method and the like. In the formation of the film, it is preferred to imidize the coating by drying it at 50-250°C and then heating it to about 250-400°C.

In the processes of the present invention the adhesion of the polyimide to various substrates is important. It is preferred to roughen the surface of inorganic materials or to treat the surface with a silane coupling agent, titanate coupling agent, aluminum alcoholate, aluminum chelate, zirconium chelate, aluminum acetylacetonate, or the like. These surface treating agents may be added to the polyimide or its precursor. Alternatively, diamines or tetracarboxylic acid dianhydrides having a siloxane skeleton may be copolymerized therewith.

In the processes of the present invention, when the polyimide skeleton has a linear conformation, the thermal expansion coefficient of the film is very small, and the modulus thereof is increased, but it is also possible to decrease the heat expansion coefficient, to increase the modulus, and to control the fluidity by incorporating therein powders, fibers, chopped strands or the like of inorganic materials, organic materials or metals.

Further, the polyimide precursors used in the processes of the present invention in which acidic functional groups such as carboxy groups or sulfone groups are masked can be used as a conductive coating composition by adding thereto minutes of metallic materials such as a metallic powder of copper or silver.

In the following, the invention will be explained with reference to the drawings.
Fig. 1 is a schematical cross-sectional view illustrating a high-density wiring board which is one specific example of the present invention;
Fig. 2 is a schematical cross-sectional view illustrating an example of application of the present invention to a package substrate for multi-chip modules.

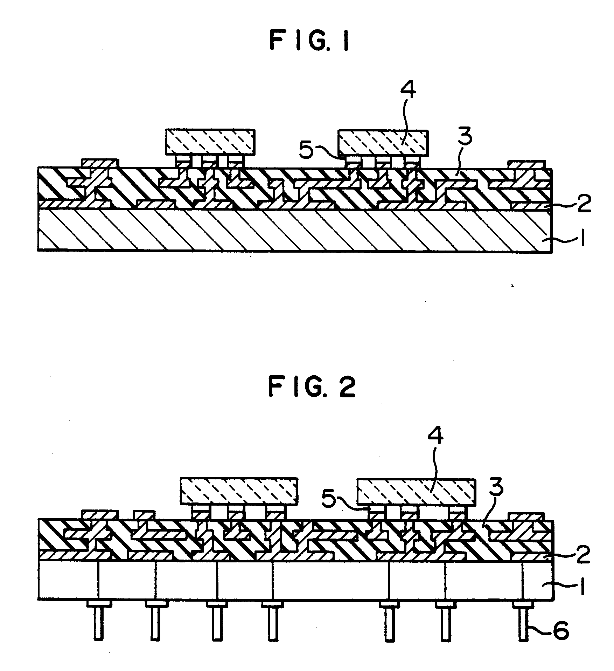

The present invention is applied to the production of multi-chip modulus shown in Figs. 1 and 2. A pattern of a copper film 2 is formed on an insulating substrate or circuit board 1 by vacuum evaporation. Patterning of the copper film 2 is performed by chemical etching or dry etching which are well known in the art.

A varnish of a precursor (i.e. a polyamic acid ester) of a polyimide is coated on the patterned copper film 2; then the coating of the precursor is dried and heated to effect imidization of the precursor. The polyimide film 3 is then patterned to form one or more through-holes by etching with hydrazine or by dry etching by means of an ion milling apparatus. Another copper film is deposited on the patterned polyimide film so that the lower copper film and upper copper film are electrically connected. Then, the upper copper film is patterned thereby to form desired circuits. After the desired number of layers of copper films and polyimide films are formed, semiconductor chips 4 are bonded to the patterned copper film through CCB 5.

Fig. 2 shows an LSI package of ceramic pin grid array type in which the multi-layer circuit board comprising a copper film 2 and the polyimide layer 3 is produced in the same manner as in Fig. 1. The circuit board comprises pins 6.

The following nonlimiting examples explain the present invention specifically.

### Example 1

p-PDA was reacted with s-BPDA by the conventional method to obtain a 15% solution of polyamic acid in N-methyl-2-pyrrolidone (abbreviated to "NMP" hereinafter). To this solution was added an equivalent amount of phenylglycidyl ether, and the reaction was allowed to proceed in the presence of benzyldimethylamine at 80°C for 5 h to obtain a hydroxy esterified polyamic acid. The addition amount of benzyldimethylamine was 2% by weight of the phenylglycidyl ether.

This polyamic acid epoxy adduct varnish was spin coated on to the surface of a silicon wafer having a copper thin film vapor deposited thereon to form a film of 15 »m in thickness. The heating conditions for imidization were heating at 100°C for 30 min, heating from 100°C to 400°C over 1 h, and keeping at that temperature for 30 min. The heating atmosphere was air.

This polyimide film was peeled from the silicon wafer, and the copper content in this film, the color, the heat decomposition temperature and the tensile strength were measured. It was found that this film contained only 0.02% (atomic-absorption method) of copper, the color of the film was brown, and this was nearly the same as with a film formed on an inert SiO₂ film (Comparative Example 1), the decomposition temperature in air was 505°C, the tensile strength was 400 MPa, and the elongation was 20%. This shows that this film had conspicuously excellent heat resistance and mechanical properties.

Furthermore, the film was dipped in an etching solution for copper for about 5 h, and then the heat decomposition temperature and the mechanical properties were measured. It was found that the values were nearly the same as those of the film which was not dipped in the etching solution, and thus the film was chemically very stable.

### Comparative Example 1

A 15% NMP solution of a polyamic acid obtained from p-PDA and s-BPDA was spin coated onto the surface of a silicon wafer provided with a silicon oxide film to form a film of a thickness of 15 »m. The conditions for the imidization with heating were the same as in Example 1. The polyimide film was peeled from the silicon wafer, and color, heat decomposition temperature and tensile strength were measured. This film had a brown color, a decomposition temperature in air of 510°C, a tensile strength of 350 MPa and an elongation of 25%, i.e., had very excellent heat resistance and mechanical properties. It can be seen that the polyimide film of Example 1 had characteristics similar to those of this film formed on an inert surface such as the thermally oxidized film. The content of copper in this film was naturally very low, namely, less than 0.0003%.

Furthermore, this film was dipped in an etching solution for copper for about 5 h, and then the heat decomposition temperature and the mechanical properties of this film were measured to find that this film had nearly the same values as those of the film which was not dipped in the etching solution, and was chemically very stable as in Example 1.

### Comparative Example 2

In the same manner as in Example 1, a copper thin film was vapor deposited on a silicon wafer, a pattern was formed by etching, and thereon was coated the same polyamic acid varnish as used in Comparative Example 1 and imidized with heating under the same conditions as in Example 1. As a result, discoloration of the polyimide film on the copper pattern to blackish brown occurred, and when the film was peeled, it was torn off from the discolored portion of the copper pattern. Separately, copper was vapor deposited on a silicon wafer as above and then, a polyamic acid varnish was coated thereon without forming a pattern and was imidized by heating. Thereafter, it was dipped in an etching solution for copper, and the film was peeled therefrom. The content of copper in this film was very high, namely, 0.3%. This film had a heat decomposition starting temperature of 330°C and thus was inferior in heat resistance by nearly 200°C as compared with the film formed on an inert film, and besides, the film strength and elongation were much deteriorated, namely being, 150 MPa and 3%, respectively. These properties seem to be caused by dissolution of copper due to the presence of carboxy groups, in the polyamic acid which is a polyimide precursor and the deterioration of imide rings due to oxidation with copper in the film.

### Comparative Example 3

In place of copper used in Comparative Example 2, a silver film was formed on a silicon wafer by vapor deposition, and the same polyamic acid varnish as in Comparative Example 2 was coated thereon and imidized by heating. The polyimide film peeled therefrom had a heat decomposition starting temperature of 400°C which was better than when the film was formed on a copper film, but was inferior in heat resistance by nearly 100°C as compared with the film formed on an inert film, and besides, the film was much inferior in film strength and elongation, which were 220 kPa and 6%, respectively. These properties seem to be caused by dissolution of silver due to the presence of carboxy groups in the polyamic acid which is a polyimide precursor and the deterioration of imide rings by oxidation with silver in the film.

### Comparative Example 4

In place of copper in Comparative Example 2, a nickel film was formed on a silicon wafer by vapor deposition, and the same polyamic acid varnish as used in Comparative Example 2 was coated thereon and imidized by heating. Then, the material was dipped in an etching solution for nickel, and the film was peeled therefrom. This polyimide film had a heat decomposition temperature of 495°C and was equal to the film formed on an inert film in heat resistance and considerably superior to the film formed on copper film. Besides, film strength and elongation were 290 MPa and 17%, respectively, which caused no severe problems. The amount of nickel dissolved due to the presence of carboxy groups in the polyamic acid which is a polyimide precursor was very small. In the case of nickel, the deterioration of imide rings due to oxidation is not so severe.

### Comparative Example 5

The same polyamic acid varnish as used in Comparative Example 2 was coated on a thin copper film vapor deposited on a silicon wafer and imidized by heating in the same manner as in Comparative Example 2 except that the atmosphere for curing by heating was not air, but nitrogen gas containing a small amount of hydrogen, namely, a slightly reducing atmosphere. As a result, no change was seen in the polyimide film. The heat decomposition starting temperature of the polyimide film obtained by removing the copper by etching was 500°C, namely, the heat decomposition characteristic of this film, was markedly better than the film imidized by heating in air and nearly the same as the film cured on an inert film. Besides, film strength and elongation were 350 MPa and 21%, respectively, and were somewhat inferior as compared with those of the polyimide film formed on SiO₂ film, but it was recognized that the film was subject to substantially no influence of copper. It seems that copper was dissolved due to the presence of carboxy groups in the polyamic acid which is a polyimide precursor, but the copper in the film became inert by the heat treatment in the reducing atmosphere.

### Example 2

In the same manner as in Example 1, DDE and PMDA were brought to reaction by the conventional method to obtain a 15% solution of polyamic acid in N-methyl-2-pyrrolidone (abbreviated to "NMP" hereinafter). Further, in the same manner as in Example 1, this solution was brought to reaction with an equivalent amount of phenylglycidyl ether in the presence of benzyldimethylamine at 80°C for 5 h to obtain a polyamic acid epoxy adduct. The addition amount of benzyldimethylamine was 2% by weight of the phenylglycidyl ether.

This polyamic acid epoxy adduct varnish was spin coated on the surface of a silicon wafer having a thin copper film vapor deposited thereon to form a film of 15 »m in thickness. The heating conditions for imidization were heating at 100°C for 30 min, heating from 100°C to 400°C over 1 h, and keeping at that temperature for 30 min. The heating atmosphere was air. This polyimide film was peeled from the silicon wafer, and the copper content in this film, the color, the heat decomposition temperature and the tensile strength were measured. It was found that this film contained only 0.03% (atomic-absorption method) of copper, the color of the film was brown and this was nearly the same as with the film formed on an inert SiO₂ film; the decomposition temperature in air was 460°C, the tensile strength was 180 MPa, and the elongation was 25%. This shows that this film has conspicuously excellent heat resistance and mechanical properties. These values were nearly the same as those of the film formed on an SiO₂ film.

### Example 3

o-TLD and BTDA were brought to reaction by the conventional method to obtain a 15% NMP solution of the polyamic acid. Furthermore, thereto was added phenyl isocyanate in an amount of 2 times the mol an amount of BDTA, and the reaction was allowed to proceed for 5 h at room temperature and for 2 h at 80°C to obtain an amido polyamic acid.

This amido polyamic acid varnish was spin coated on the surface of a silicon wafer having a thin copper film vapor deposited thereon to form a film of 10 »m in thickness. The heating conditions for the imidization were the same as those in Example 1. This polyimide film was peeled from the silicon wafer, and the content of copper in the film, the color, the heat decomposition temperature and the tensile strength were measured. As a result, the film contained only 0.01% of copper and had a brown color which was nearly the same as that of the film formed on an inert SiO₂ film. Furthermore, this film had markedly excellent heat resistance and mechanical properties, namely, a decomposition temperature of 430°C in air, a tensile strength of 370 MPa, and an elongation of 17%.

### Example 4

Diphenylmethane diisocyanate (MDI) and s-BPDA were reacted by the conventional method to obtain a 15% NMP solution of the polyimide precursor.

This varnish was spin coated on the surface of a silicon wafer having a thin copper film vapor deposited thereon to form a film of 15 »m in thickness. Heating for imidization was carried out in air as in Example 1. This polyimide film was peeled from the silicon wafer, and the content of copper in the film, the color, the heat decomposition temperature and the tensile strength were measured. As a result, the film contained only 0.015% (atomic-absorption method) of copper and had brown color which was nearly the same as that of the film formed on an inert SiO₂ film. Furthermore, this film had markedly excellent heat resistance and mechanical properties, namely, a decomposition temperature of 500°C in air, a tensile strength of 330 MPa, and an elongation of 19%.

As explained above, the present invention provides a method for producing metal/polyimide composite articles according to which the oxidative deterioration of polyimide films which has been a problem when a polyamic acid is coated and cured on copper or silver can be prevented without necessity to carry out the curing in a reducing atmosphere or to use esterified polyamic acids difficult to prepare and imidized varnishes having problems in solubility.

## Claims

1. A process for producing copper or silver polyimide composite articles, comprising:
Providing a precursor of a polyimide in contact with copper or silver (2) and
heating the precursor until it turns into the polyimide (3), wherein the precursor is selected from polyamic acid epoxy adducts, amido polyamic acids, and reaction products of an organic diisocyanate compound and a tetracarboxylic acid dianhydride.

2. The process according to claim 1, wherein the polyamic acid epoxy adduct is at least one member selected from the group consisting of compounds I and II represented by the following general formulae: 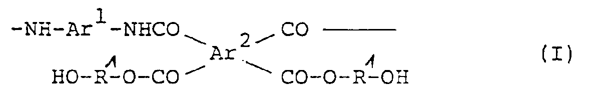 and 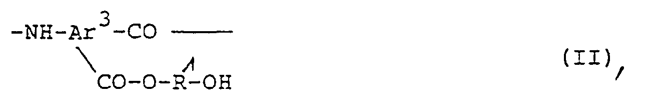 wherein are:
R¹ a residue of an epoxy compound,
Ar¹ a residue of a diamine compound,
Ar² a residue of a tetracarboxylic acid, and
Ar³ a residue of an aminodicarboxylic acid.

3. The process according to claim 1 or 2, wherein the amido polyamic acid is at least one member selected from the group consisting of compounds III and IV represented by the following general formulae: 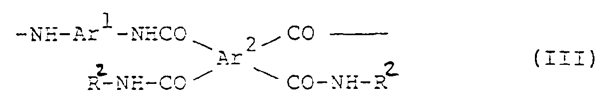 and 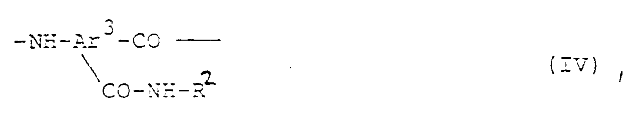 wherein Ar¹, Ar², Ar³ are as in claim 2, and R² is a residue of an isocyanate.

4. The process according to one of claims 1 to 3, wherein the reaction product of a diisocyanate and a tetracarboxylic acid dianhydride has the general formula V 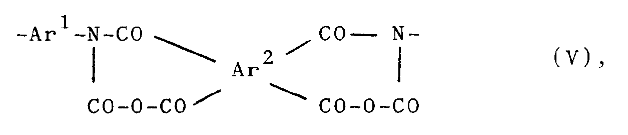 wherein
Ar² is as in claim 2, and
Ar¹ is a residue of a diisocyanate.

5. A process for producing printed circuit boards, comprising the following steps:
Forming a copper film (2) on an electrically insulating substrate (1);
coating a precursor of a polyimide on the copper film (2) and
heating the polyimide precursor until it turns into the polyimide (3), wherein the polyimide precursor used is selected from polyamic acid epoxy adducts, amido polyamic acids, and reaction products of an organic diisocyanate compound and a tetracarboxylic acid dianhydride.

6. The process according to claim 5, wherein the polyamic acid epoxy adduct is at least one member selected from the group consisting of compounds I and II represented by the following general formulae: 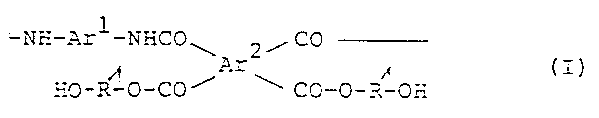 and 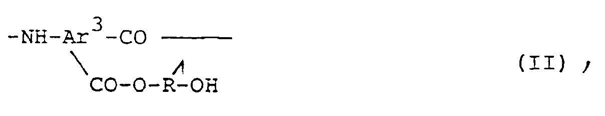 wherein are:
R¹ a residue of an epoxy compound,
Ar¹ a residue of a diamine compound,
Ar² a residue of a tetracarboxylic acid, and
Ar³ a residue of an aminodicarboxylic acid.

7. The process according to claim 5 or 6, wherein the amido polyamic acid is at least one member selected from the group consisting of compounds III and IV represented by the following general formulae: 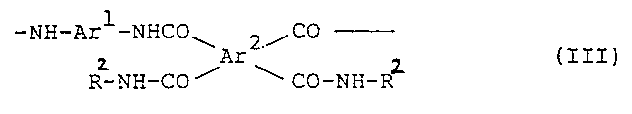 and 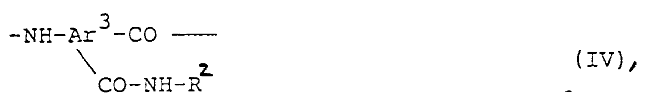 wherein
Ar¹, Ar², Ar³ are as in claim 6, and
R² is a residue of an isocyanate.

8. The process according to one of claims 5 to 7, wherein the reaction product of a diisocyanate and a tetracarboxylic acid dianhydride has the general formula V 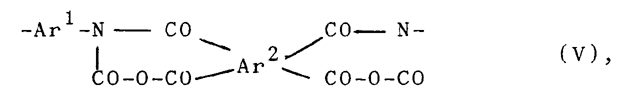 wherein
Ar² is as in claim 6, and
Ar¹ is a residue of a diisocyanate.

9. A process for producing copper or silver polyimide compositions, comprising:
Providing a homogeneous mixture of a precursor of a polyimide, minutes of copper or silver and an organic solvent for dissolving the polyimide precursor, and
heating the mixture until the polyimide precursor turns into the polyimide (3), wherein the polyimide precursor used is selected from polyamic acid epoxy adducts, amido polyamic acids, and reaction products of an organic diisocyanate compound and a tetracarboxylic acid dianhydride.

10. The process according to claim 9, wherein the polyamic acid epoxy adduct is at least one member selected from the group consisting of compounds I and II represented by the following general formulae: 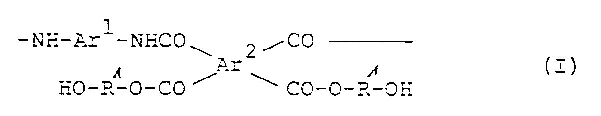 and 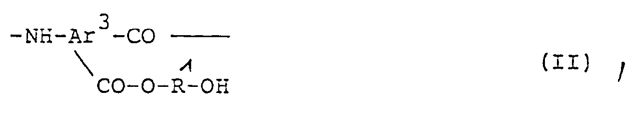 wherein are:
R¹ a residue of an epoxy compound,
Ar¹ a residue of a diamine compound,
Ar² a residue of a tetracarboxylic acid, and
Ar³ a residue of an aminodicarboxylic acid.

11. The process according to claim 9 or 10, wherein the amido polyamic acid is at least one member selected from the group consisting of compounds III and IV represented by the following general formulae: 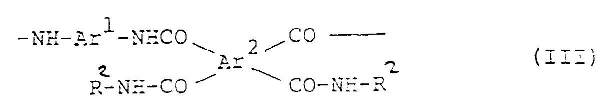 and 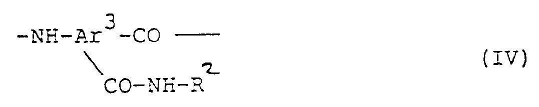 wherein
Ar¹, Ar², Ar³ are as in claim 10, and
R² is a residue of an isocyanate.

12. The process according to one of claims 9 to 11, wherein the reaction product of a diisocyanate and a tetracarboxylic acid dianhydride has the general formula V 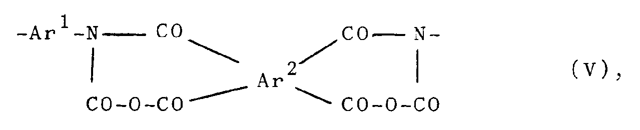 wherein
Ar² is as in claim 10, and
Ar¹ is a residue of a diisocyanate.

13. A process for producing a multi-layer printed circuit board, comprising the following steps:
(A) Forming a circuit pattern of a copper film (2) on an electrically insulating substrate (1),
(B) coating a varnish of a precursor of a polyimide on the circuit pattern,
(C) heating the varnish until the polyimide precursor turns into the polyimide (3),
(D) patterning the polyimide (3) to form through-holes therein, and
(E) forming a circuit pattern of copper (2) on the patterned polyimide (3),
steps B to E being repeated until a desired number of layers is obtained, wherein the polyimide precursor is selected from polyamic acid epoxy adducts, amido polyamic acids, and reaction products of an organic diisocyanate compound and a tetracarboxylic acid dianhydride.

14. The process according to claim 13, wherein the polyamic acid epoxy adduct is at least one member selected from the group consisting of compounds I and II represented by the following general formulae: 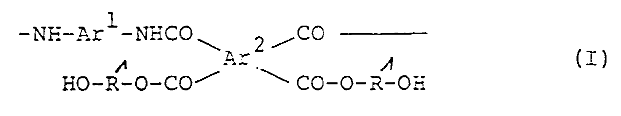 and 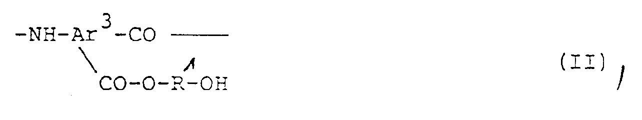 wherein are:
R¹ a residue of an epoxy compound,
Ar¹ a residue of a diamine compound,
Ar² a residue of a tetracarboxylic acid, and
Ar³ a residue of an aminodicarboxylic acid.

15. The process according to claim 13 or 14, wherein the amido polyamic acid is at least one member selected from the group consisting of compounds III and IV represented by the following general formulae: 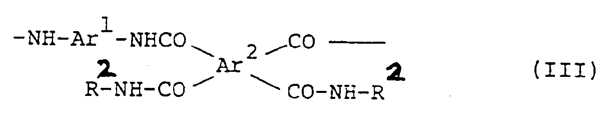 and 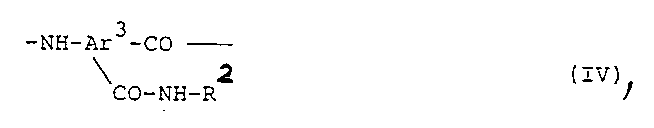 wherein
Ar¹, Ar², Ar³ are as in claim 14, and
R² is a residue of an isocyanate.

16. The process according to one of claims 13 to 15, wherein the reaction product of a diisocyanate and a tetracarboxylic acid dianhydride has the general formula V 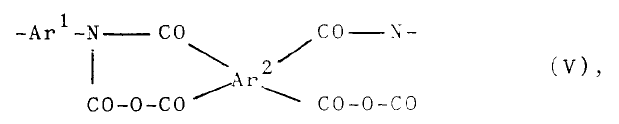 wherein
Ar² is as in claim 14, and
Ar¹ is a residue of a diisocyanate.

## Patentansprüche

1. Verfahren zur Herstellung von Kupfer- oder Silber-Polyimid-Verbundwerkstoffen, das folgende Schritte umfaßt:
Vorsehen eines Polyimid-Vorläufers im Kontakt mit Kupfer oder Silber (2) und
Erhitzen des Vorläufers, bis es sich in das Polyimid (3) umwandelt, wobei der Polyimid-Vorläufer unter Polyamidsäure-Epoxy-Addukten, Amidopolyamidsäuren und Reaktionsprodukten einer organischen Diisocyanatverbindung mit einem Tetracarbonsäuredianhydrid ausgewählt ist.

2. Verfahren nach Anspruch 1, wobei das Polyamidsäure-Epoxy-Addukt mindestens eine Verbindung ist, die unter den Verbindungen I und II der nachstehenden allgemeinen Formeln 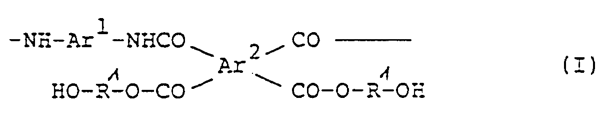 und 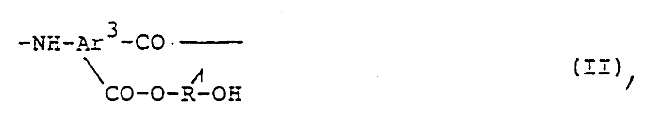 ausgewählt ist, worin bedeuten:
R¹ einen Rest einer Epoxyverbindung,
Ar¹ einen Rest einer Diaminverbindung,
Ar² einen Rest einer Tetracarbonsäure und
Ar³ einen Rest einer Aminodicarbonsäure.

3. Verfahren nach Anspruch 1 oder 2, wobei die Amidopolyamidsäure mindestens eine Verbindung ist, die unter den Verbindungen III und IV der nachstehenden allgemeinen Formeln 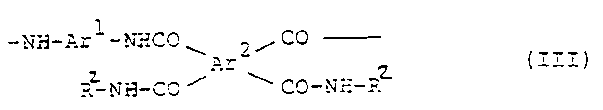 und 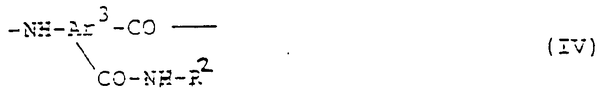 ausgewählt ist, worin Ar¹, Ar² und Ar³ dasselbe wie in Anspruch 2 und R² einen Rest eines Isocyanats bedeuten.

4. Verfahren nach einem der Ansprüche 1 bis 3, wobei das Reaktionsprodukt eines Diisocyanats mit einem Tetracarbonsäuredianhydrid die allgemeine Formel V 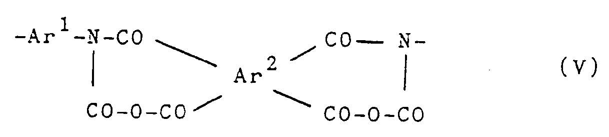 besitzt, worin
Ar² dasselbe wie in Anspruch 2 und
Ar¹ einen Rest eines Diisocyanats
bedeuten.

5. Verfahren zur Herstellung gedruckter Leiterplatten,
das folgende Schritte umfaßt:
- Erzeugung einer dünnen Schicht aus Kupfer (2) auf einem elektrisch isolierenden Substrat (1),
- Aufbringen eines Polyimid-Vorläufers auf der Schicht aus Kupfer (2) und
- Erhitzen des Polyimid-Vorläufers, bis er sich in das Polyimid (3) umwandelt, wobei der eingesetzte Polyimid-Vorläufer unter Polyamidsäure-Epoxy-Addukten, Amidopolyamidsäuren und Reaktionsprodukten einer organischen Diisocyanatverbindung mit einem Tetracarbonsäuredianhydrid ausgewählt ist.

6. Verfahren nach Anspruch 5, wobei das Polyamidsäure-Epoxy-Addukt mindestens eine Verbindung ist, die unter den Verbindungen I und II der nachstehenden allgemeinen Formeln 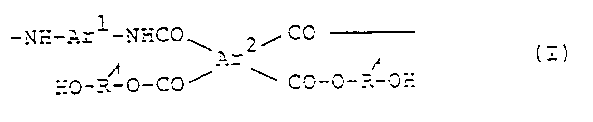 und 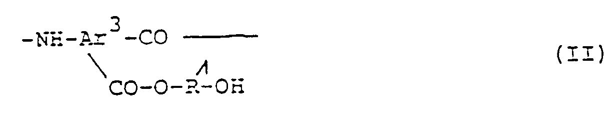 ausgewählt ist,
worin bedeuten:
R¹ einen Rest einer Epoxyverbindung,
Ar¹ einen Rest einer Diaminverbindung,
Ar² einen Rest einer Tetracarbonsäure und
Ar³ einen Rest einer Aminodicarbonsäure.

7. Verfahren nach Anspruch 5 oder 6, wobei die Amidopolyamidsäure mindestens eine Verbindung ist, die unter den Verbindungen III und IV der nachstehenden allgemeinen Formeln 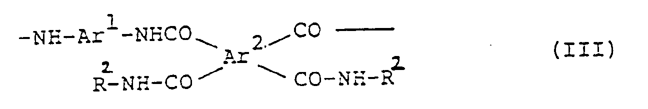 und 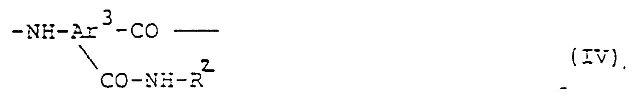 ausgewählt ist, worin Ar¹, Ar² und Ar³ dasselbe wie in Anspruch 6 und R² einen Rest eines Isocyanats bedeuten.

8. Verfahren nach einem der Ansprüche 5 bis 7, wobei das Reaktionsprodukt eines Diisocyanats mit einem Tetracarbonsäuredianhydrid die allgemeine Formel V 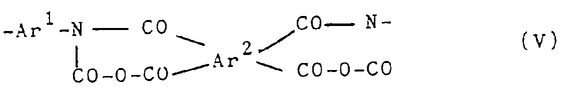 besitzt, worin
Ar² dasselbe wie in Anspruch 6 und
Ar¹ einen Rest eines Diisocyanats bedeuten.

9. Verfahren zur Herstellung von Kupfer- oder Silber-Polyimid-Zusammensetzungen, das folgende Schritte umfaßt:
Vorsehen eines homogenen Gemischs aus einem Polyimid-Vorläufer, feinteiligem Kupfer oder Silber und einem organischen Lösungsmittel zum Lösen des Polyimid-Vorläufers
und
Erhitzen des Gemischs, bis sich der Polyimid-Vorläufer in das Polyimid (3) umwandelt, wobei der Polyimid-Vorläufer unter Polyamidsäure-Epoxy-Addukten, Amidopolyamidsäuren und Reaktionsprodukten einer organischen Diisocyanatverbindung mit einem Tetracarbonsäuredianhydrid ausgewählt ist.

10. Verfahren nach Anspruch 9, wobei das Polyamidsäure-Epoxy-Addukt mindestens eine Verbindung ist, die unter den Verbindungen I und II der nachstehenden allgemeinen Formeln 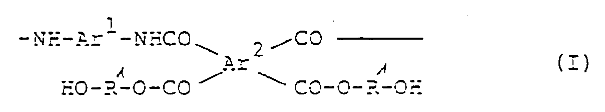 und 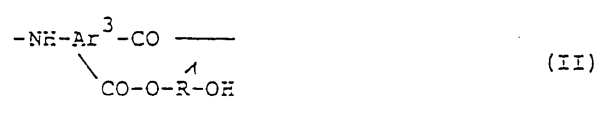 ausgewählt ist,
worin bedeuten:
R¹ einen Rest einer Epoxyverbindung,
Ar¹ einen Rest einer Diaminverbindung,
Ar² einen Rest einer Tetracarbonsäure und
Ar³ einen Rest einer Aminodicarbonsäure.

11. Verfahren nach Anspruch 9 oder 10, wobei die Amidopolyamidsäure mindestens eine Verbindung ist, die unter den Verbindungen III und IV der nachstehenden allgemeinen Formeln 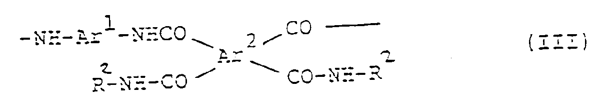 und 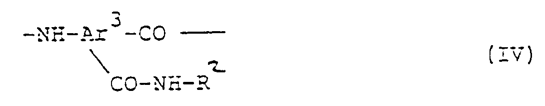 ausgewählt ist, worin Ar¹, Ar² und Ar³ dasselbe wie in Anspruch 10 und R² einen Rest eines Isocyanats bedeuten.

12. Verfahren nach einem der Ansprüche 9 bis 11, wobei das Reaktionsprodukt eines Diisocyanats mit einem Tetracarbonsäuredianhydrid die allgemeine Formel V 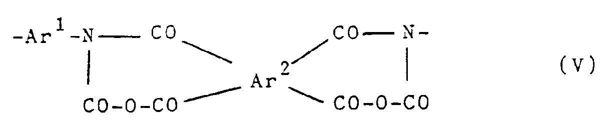 besitzt, worin
Ar² dasselbe wie in Anspruch 10 und
Ar¹ einen Rest eines Diisocyanats bedeuten.

13. Verfahren zur Herstellung von gedruckten Multilayer-Leiterplatten, das folgende Schritte umfaßt:
(A) Erzeugung eines Schaltungsmusters aus einer dünnen Schicht aus Kupfer (2) auf einem elektrisch isolierenden Substrat (1),
(B) Aufbringen eines Lacks aus einem Polyimid-Vorläufer auf dem Schaltungsmuster,
(C) Erhitzen des Lacks, bis sich der Polyimid-Vorläufer in das Polyimid (3) umwandelt,
(D) Ausbildung eines Bildmusters aus dem Polyimid (3) zur Erzeugung von Durchgangslöchern darin und
(E) Erzeugung eines Schaltungsmusters aus Kupfer (2) auf dem als Bildmuster ausgebildeten Polyimid (3),
wobei die Schritte B bis E wiederholt werden, bis eine erwünschte Anzahl von Schichten erhalten wird, wobei der Polyimid-Vorläufer unter Polyamidsäure-Epoxy-Addukten, Amidopolyamidsäuren und Reaktionsprodukten einer organischen Diisocyanatverbindung mit einem Tetracarbonsäuredianhydrid ausgewählt ist.

14. Verfahren nach Anspruch 13, wobei das Polyamidsäure-Epoxy-Addukt mindestens eine Verbindung ist, die unter den Verbindungen I und II der nachstehenden allgemeinen Formeln 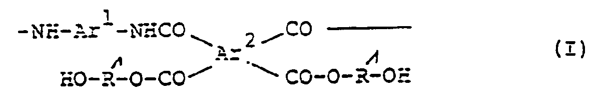 und 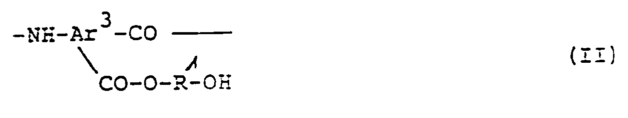 ausgewählt ist,
worin bedeuten:
R¹ einen Rest einer Epoxyverbindung,
Ar¹ einen Rest einer Diaminverbindung,
Ar² einen Rest einer Tetracarbonsäure und
Ar³ einen Rest einer Aminodicarbonsäure.

15. Verfahren nach Anspruch 13 oder 14, wobei die Amidopolyamidsäure mindestens eine Verbindung ist, die unter den Verbindugnen III und IV der nachstehenden allgemeinen Formeln 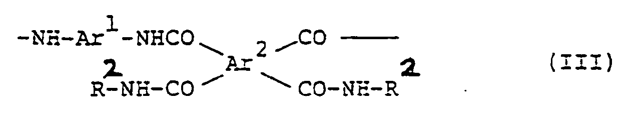 und 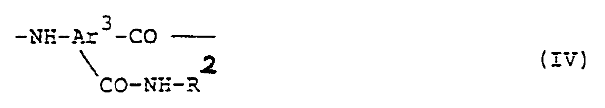 ausgewählt ist, worin Ar¹, Ar² und Ar³ dasselbe wie in Anspruch 14 und R² einen Rest eines Isocyanats bedeuten.

16. Verfahren nach einem der Ansprüche 13 bis 15, wobei das Reaktionsprodukt eines Diisocyanats mit einem Tetracarbonsäuredianhydrid die allgemeine Formel V 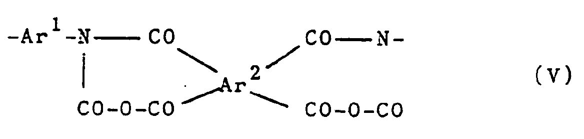 besitzt, worin
Ar² dasselbe wie in Anspruch 14 und
Ar¹ einen Rest eines Diisocyanats bedeuten.

## Revendications

1. Procédé de production d'articles composites cuivre- ou argent-polyimide, comprenant les étapes consistant à :
mettre un précurseur d'un polyimide en contact avec du cuivre ou de l'argent (2) et
chauffer le précurseur jusqu'à ce qu'il se transforme en le polyimide (3), dans lequel le précurseur est choisi parmi des produits d'addition acide polyamique-époxy, des acides amidopolyamiques, et des produits de réaction d'un composé diisocyanate organique et d'un dianhydride d'acide tétracarboxylique.

2. Procédé selon la revendication 1, dans lequel le produit d'addition acide polyamique-époxy est au moins un élément du groupe constitué des composés I et II représentés par les formules générales suivantes : 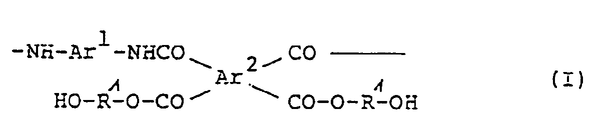 et 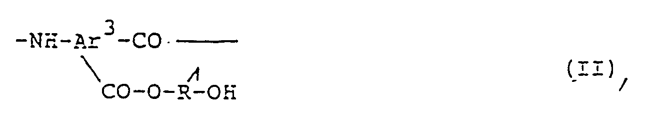 dans lesquelles :
R¹ représente un reste d'un composé époxy
Ar¹ représente un reste d'un composé diamine
Ar² représente un reste d'un acide tétracarboxylique, et
Ar³ représente un reste d'un acide aminodicarboxylique.

3. Procédé selon la revendication 1 ou 2, dans lequel l'acide amidopolyamique est au moins un élément du groupe constitué des composés III et IV représentés par les formules générales suivantes : 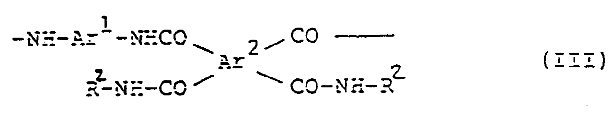 et 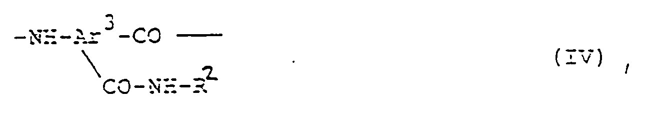 dans lesquelles Ar¹, Ar², Ar³ sont tels que dans la revendication 2, et R² représente un reste d'un isocyanate.

4. Procédé selon l'une des revendications 1 à 3, dans lequel le produit de réaction d'un diisocyanate et d'un dianhydride d'acide tétracarboxylique répond à la formule générale V : 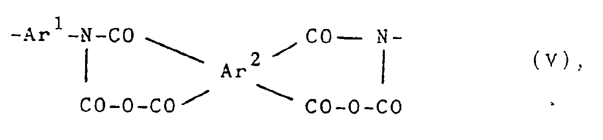 dans laquelle
Ar² est tel que dans la revendication 2, et
Ar¹ est un reste d'un diisocyanate.

5. Procédé de production de plaquettes à circuits imprimés, qui comprend les étapes consistant à :
former un film de cuivre (2) sur un substrat électriquement isolant (1) ;
déposer un précurseur d'un polyimide sur le film de cuivre (2) et
chauffer le précurseur de polyimide jusqu'à ce qu'il se transforme en le polyimide (3), dans lequel le précurseur de polyimide utilisé est choisi parmi des produits d'addition acide polyamique-époxy, des acides amidopolyamiques, et des produits de réaction d'un composé diisocyanate organique et d'un dianhydride d'acide tétracarboxylique.

6. Procédé selon la revendication 5, dans lequel le produit d'addition acide polyamique-époxy est au moins un élément du groupe constitué des composés I et II représentés par les formules générales suivantes : 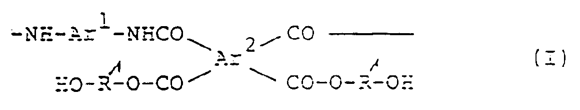 et 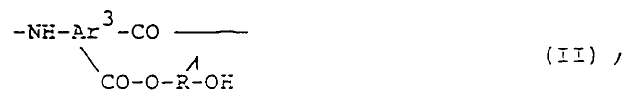 dans lesquelles :
R¹ représente un reste d'un composé époxy
Ar¹ représente un reste d'un composé diamine
Ar² représente un reste d'un acide tétracarboxylique, et
Ar³ représente un reste d'un acide aminodicarboxylique.

7. Procédé selon la revendication 5 ou 6, dans lequel l'acide amidopolyamique est au moins un élément du groupe constitué des composés III et IV représentés par les formules générales suivantes : 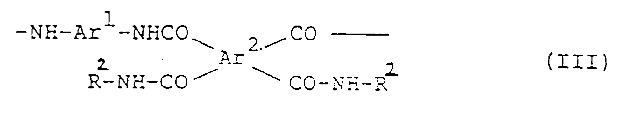 et 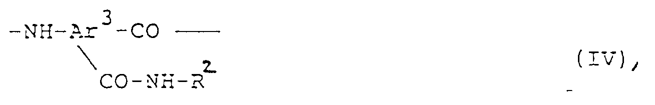 dans lesquelles Ar1, Ar², Ar³ sont tels que dans la revendication 6, et R² représente un reste d'un isocyanate.

8. Procédé selon l'une des revendications 5 à 7, dans lequel le produit de réaction d'un diisocyanate et d'un dianhydride d'acide tétracarboxylique répond à la formule générale V : 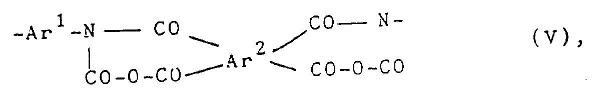 dans laquelle
Ar² est tel que dans la revendication 6, et
Ar¹ est un reste d'un diisocyanate.

9. Procédé de production de compositions cuivre- ou argent-polyimide, comprenant les étapes consistant à
fournir un mélange homogène d'un précurseur d'un polyimide, de petites particules de cuivre ou d'argent et d'un solvant organique pour dissoudre le précurseur de polyimide, et
chauffer le mélange jusqu'à ce que le précurseur de polyimide se transforme en le polyimide (3), dans lequel le précurseur de polyimide est choisi parmi des produits d'addition acide polyamique-époxy, des acides amidopolyamiques, et des produits de réaction d'un composé diisocyanate organique et d'un dianhydride d'acide tétracarboxylique.

10. Procédé selon la revendication 9, dans lequel le produit d'addition acide polyamique-époxy est au moins un élément du groupe constitué des composés I et II représentés par les formules générales suivantes : 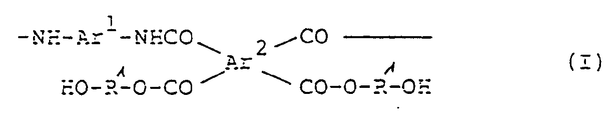 et 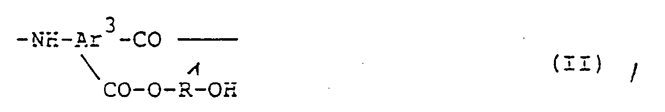 dans lesquelles :
R¹ représente un reste d'un composé époxy
Ar¹ représente un reste d'un composé diamine
Ar² représente un reste d'un acide tétracarboxylique, et
Ar³ représente un reste d'un acide aminodicarboxylique.

11. Procédé selon la revendication 9 ou 10, dans lequel l'acide amidopolyamique est au moins un élément du groupe constitué des composés III et IV représentés par les formules générales suivantes : 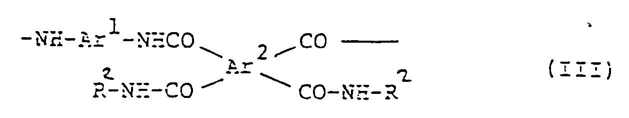 et 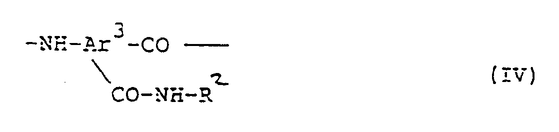 dans lesquelles Ar¹, Ar², Ar³ sont tels que dans la revendication 10, et R² représente un reste d'un isocyanate.

12. Procédé selon l'une des revendications 9 à 11, dans lequel le produit de réaction d'un diisocyanate et d'un dianhydride d'acide tétracarboxylique répond à la formule générale V : 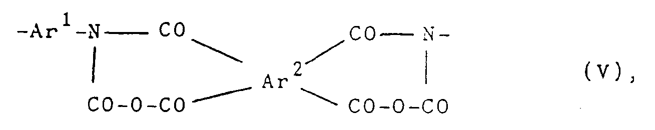 dans laquelle
Ar² est tel que dans la revendication 10, et
Ar¹ est un reste d'un diisocyanate.

13. Procédé de production de plaquettes à circuits imprimés à plusieurs couches, qui comprend les étapes consistant à :
(A) former un circuit imprimé en un film de cuivre (2) sur un substrat électriquement isolant (1),
(B) déposer un vernis d'un précurseur d'un polyimide sur le circuit imprimé,
(C) chauffer le vernis jusqu'à ce que le précurseur de polyimide se transforme en le polyimide (3),
(D) imprimer le polyimide (3) pour y former des trous débouchants, et
(E) former un circuit imprimé de cuivre (2) sur le polyimide imprimé (3),
les étapes B à E étant répétées jusqu'à l'obtention d'un nombre de couches voulu, dans lequel le précurseur de polyimide est choisi parmi des produits d'addition acide polyamique-époxy, des acides amidopolyamiques, et des produits de réaction d'un composé diisocyanate organique et d'un dianhydride d'acide tétracarboxylique.

14. Procédé selon la revendication 13, dans lequel le produit d'addition acide polyamique-époxy est au moins un élément du groupe constitué des composés I et II représentés par les formules générales suivantes : 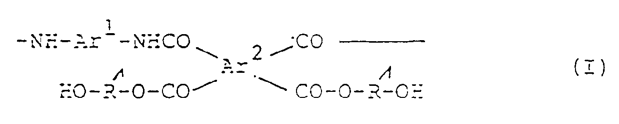 et 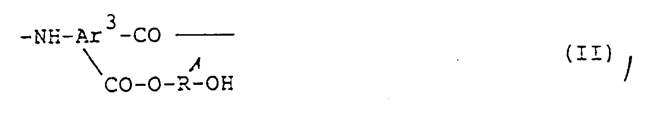 dans lesquelles :
R¹ représente un reste d'un composé époxy
Ar¹ représente un reste d'un composé diamine
Ar² représente un reste d'un acide tétracarboxylique, et
Ar³ représente un reste d'un acide aminodicarboxylique.

15. Procédé selon la revendication 13 ou 14, dans lequel l'acide amidopolyamique est au moins un élément du groupe constitué des composés III et IV représentés par les formules générales suivantes : 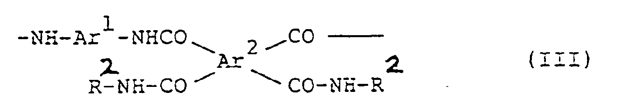 et 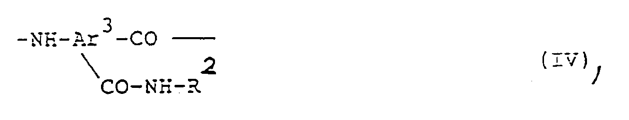 dans lesquelles Ar¹, Ar², Ar³ sont tels que dans la revendication 14,et R² représente un reste d'un isocyanate.

16. Procédé selon l'une des revendications 13 à 15, dans lequel le produit de réaction d'un diisocyanate et d'un dianhydride d'acide tétracarboxylique répond à la formule générale V : 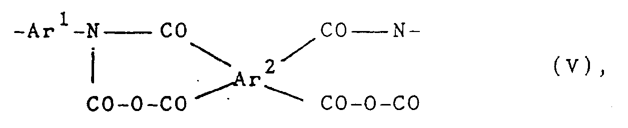 dans laquelle
Ar² est tel que dans la revendication 14, et
Ar¹ est un reste d'un diisocyanate.
